# EUROPEAN PATENT APPLICATION

(11) **EP 4 394 903 A1**
(43) Date of publication of application: **03.07.2024**
(21) Application number: 22861374.1
(22) Date of filing: 24.08.2022
(51) Int. Cl.: H01L 33/32, C23C 16/04, C30B 25/04, H01L 21/205, H01L 21/301, H01S 5/343

(54) **METHOD AND DEVICE FOR PRODUCING SEMICONDUCTOR DEVICE**

(30) Priority: 27.08.2021 JP 2021139370
(71) Applicant: Kyocera Corporation, Kyoto-shi Kyoto 612-8501 (JP)
(72) Inventor: KAMIKAWA, Takeshi, Kyoto-shi, Kyoto 612-8501 (JP); TANIGUCHI, Yuki, Kyoto-shi, Kyoto 612-8501 (JP); HAYASHI, Yuichiro, Kyoto-shi, Kyoto 612-8501 (JP); MISHIMA, Kosuke, Kyoto-shi, Kyoto 612-8501 (JP)
(74) Representative: Viering, Jentschura & Partner mbB Patent- und Rechtsanwälte
(86) International application number: PCT/JP2022/031780
(87) International publication number: WO 2023/027086

(57) **Abstract**

To prepare a semiconductor substrate (11) in which a first semiconductor part (S1) is formed above a main substrate, divide the first semiconductor part (S1) into a plurality of base semiconductor parts (8) by forming a plurality of trenches (TR) in the first semiconductor part (S1), and form a compound semiconductor part (9) above at least one of the plurality of base semiconductor parts (8).

## Description

### TECHNICAL FIELD

Embodiments of the disclosure relate generally to a semiconductor device.

### BACKGROUND OF INVENTION

Patent Document 1 discloses a technique of performing PEC etching on an element formation layer in order to separate a semiconductor device.

### CITATION LIST

### PATENT LITERATURE

Patent Document 1: JP 2020-136476 A

### SUMMARY

In the present disclosure, a manufacturing method for a semiconductor device includes preparing a semiconductor substrate in which a first semiconductor part is formed above a main substrate, dividing the first semiconductor part into a plurality of base semiconductor parts, and forming a compound semiconductor part above at least one of the plurality of base semiconductor parts.

### BRIEF DESCRIPTION OF THE DRAWINGS

FIG. 1 is a flowchart illustrating a manufacturing method for a semiconductor device according to the present embodiment.
FIG. 2 includes plan views each illustrating the manufacturing method for a semiconductor device according to the present embodiment.
FIG. 3 is a flowchart illustrating a manufacturing method for a semiconductor device according to Example 1.
FIG. 4 includes plan views each illustrating the manufacturing method for a semiconductor device according to Example 1.
FIG. 5 includes cross-sectional views each illustrating the manufacturing method for a semiconductor device according to Example 1.
FIG. 6 is a block diagram illustrating a manufacturing apparatus for the semiconductor device according to Example 1.
FIG. 7 is a partial cross-sectional view of an element portion of Example 1.
FIG. 8 is a partial plan view of the element portion of Example 1.
FIG. 9 is a partial cross-sectional view of the element portion of Example 1.
FIG. 10 includes cross-sectional views each illustrating a configuration of the semiconductor device of Example 1.
FIG. 11 includes cross-sectional views each illustrating a configuration example of a template substrate.
FIG. 12 includes cross-sectional views each illustrating an example of lateral growth of a first semiconductor part.
FIG. 13 includes plan views each illustrating another example of the manufacturing method for a semiconductor device according to Example 1.
FIG. 14 is a flowchart illustrating another example of the manufacturing method for a semiconductor device according to Example 1.
FIG. 15 includes plan views each illustrating an example of the manufacturing method for a semiconductor device according to FIG. 14.
FIG. 16 includes cross-sectional views each illustrating the manufacturing method for a semiconductor device according to FIG. 14.
FIG. 17 is a flowchart illustrating another example of the manufacturing method for a semiconductor device according to Example 1.
FIG. 18 is a flowchart illustrating another example of the manufacturing method for a semiconductor device according to Example 1.
FIG. 19 is a flowchart illustrating another example of the manufacturing method for a semiconductor device according to Example 1.
FIG. 20 includes plan views each illustrating the manufacturing method for a semiconductor device according to FIG. 19.
FIG. 21 is a flowchart illustrating another example of the manufacturing method for a semiconductor device according to Example 1.
FIG. 22 includes plan views each illustrating the manufacturing method for a semiconductor device according to FIG. 21.
FIG. 23 is a perspective view illustrating a configuration of the semiconductor device obtained by Example 1.
FIG. 24 is a perspective view illustrating a configuration of the semiconductor device obtained by Example 1.
FIG. 25 is a perspective view illustrating a configuration of the semiconductor device obtained by Example 1.
FIG. 26 is a perspective view illustrating a configuration of the semiconductor device obtained by Example 1.
FIG. 27 is a perspective view illustrating a configuration of the semiconductor device obtained by Example 1.
FIG. 28 is a schematic view illustrating a configuration of an electronic device including the semiconductor device obtained by Example 1.
FIG. 29 is a flowchart illustrating a manufacturing method for a semiconductor device according to Example 2.
FIG. 30 includes plan views each illustrating the manufacturing method for a semiconductor device according to Example 2.
FIG. 31 includes cross-sectional views each illustrating the manufacturing method for a semiconductor device according to Example 2.
FIG. 32 is a block diagram illustrating a manufacturing apparatus for the semiconductor device of Example 2.
FIG. 33A is a flowchart illustrating a manufacturing method for a semiconductor device according to Example 3.
FIG. 33B is a flowchart illustrating a manufacturing method for a semiconductor device according to Example 3.
FIG. 34 includes plan views each illustrating the manufacturing method for a semiconductor device according to Example 3.
FIG. 35 includes cross-sectional views each illustrating the manufacturing method for a semiconductor device according to Example 3.
FIG. 36 is a block diagram illustrating a manufacturing apparatus for the semiconductor device of Example 3.

### DESCRIPTION OF EMBODIMENTS

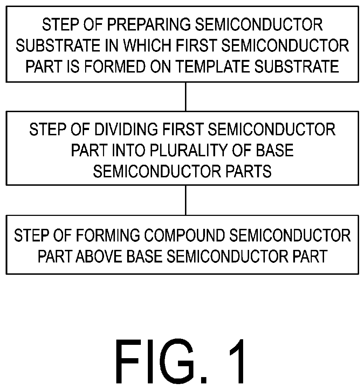

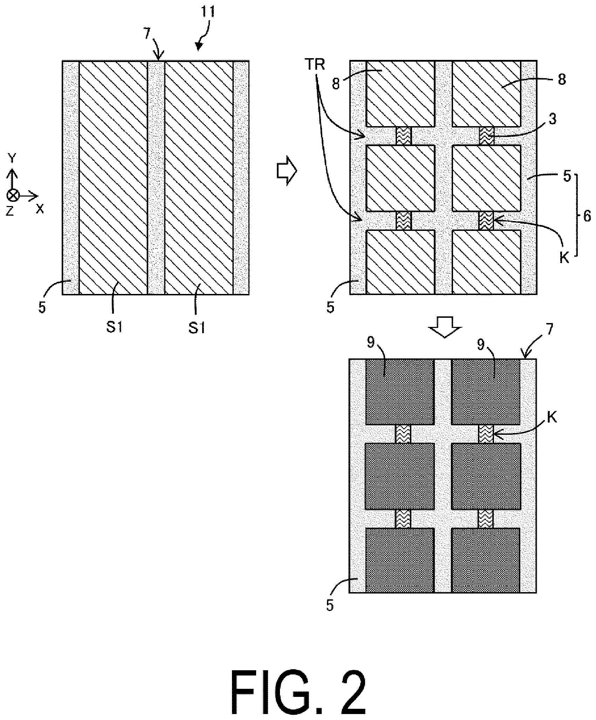

FIG. 1 is a flowchart illustrating a manufacturing method for a semiconductor device according to the present embodiment. FIG. 2 includes plan views each illustrating the manufacturing method for a semiconductor device according to the present embodiment. As illustrated in FIGs. 1 and 2, the manufacturing method for a semiconductor device according to the present embodiment performs a step of preparing a semiconductor substrate 11 in which a first semiconductor part S1 is formed on a template substrate 7 including a main substrate, a step of dividing the first semiconductor part S1 into a plurality of base semiconductor parts 8, and a step of forming a compound semiconductor part 9 above at least one of the plurality of base semiconductor parts 8.

In the known technique of etching an element formation layer, the element formation layer may be damaged by etching. In the present embodiment, the first semiconductor part S1 is divided into the plurality of base semiconductor parts 8 before the compound semiconductor part 9 is formed. Damage to an active layer of the compound semiconductor part 9 can be avoided by dividing the first semiconductor part S1 by, for example, forming a trench TR before forming the active layer, and not performing etching for element division after forming the active layer, as described above. This can improve the quality of the semiconductor device including the compound semiconductor part 9.

The template substrate 7 may include a main substrate and a mask pattern 6 including a mask portion 5 and an opening portion K, and the first semiconductor part S1 may be formed over the mask portion 5 from the opening portion K (a seed portion 3 exposed in the opening portion K). The first semiconductor part S1, the base semiconductor part 8 and the compound semiconductor part 9 may contain a nitride semiconductor (for example, a GaN-based semiconductor).

Specific examples of the semiconductor device include a light-emitting body (an LED chip, a semiconductor laser chip, or the like), a light-emitting element to which a light-emitting body is sub-mounted, and a light-emitting module in which the light-emitting element is packaged, but the semiconductor device is not limited to these semiconductor devices of a light-emitting system. For example, a light receiving element (photodiode) may be included, and in this case, the same effect as in the case of the semiconductor device of the light-emitting system can be obtained.

The nitride semiconductor may be expressed by, for example, AlxGayInzN (0 ≤ x ≤ 1; 0 ≤ y ≤ 1; 0 ≤ z ≤ 1; x + y + z = 1). Specific examples of the nitride semiconductor may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor may include GaN, AlGaN, AlGaInN, and InGaN. The base semiconductor part 8 may be of a doped type (e.g., an n-type containing a donor) or a non-doped type (i type).

The first semiconductor part S1 containing the nitride semiconductor can be formed by using an epitaxial lateral overgrowth (ELO) method. In the ELO method, the first semiconductor part S1 is laterally grown on the template substrate 7 including the mask pattern 6 (mask pattern for selective growth). In this manner, even when the main substrate included in the template substrate 7 is a heterogeneous substrate (a substrate having a lattice constant different from that of the first semiconductor part S1), a low-defect portion having a low threading dislocation density can be formed on the mask portion 5. The number of threading dislocations (dislocations extending in the thickness direction) taken over by the compound semiconductor part 9 on the low-defect portion is reduced, causing the light-emitting efficiency to be increased in the case of the semiconductor device of the light-emitting system.

### Example 1

### Manufacturing Method for Semiconductor Device

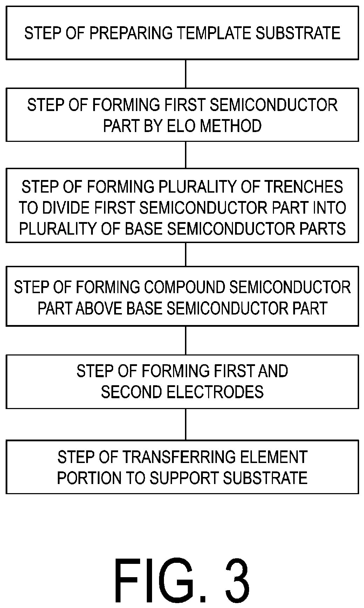

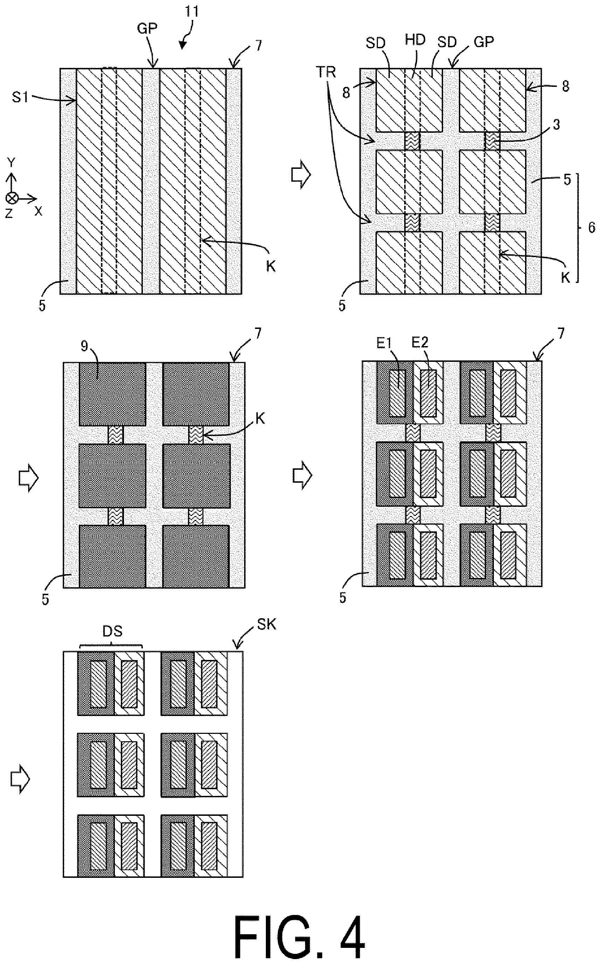

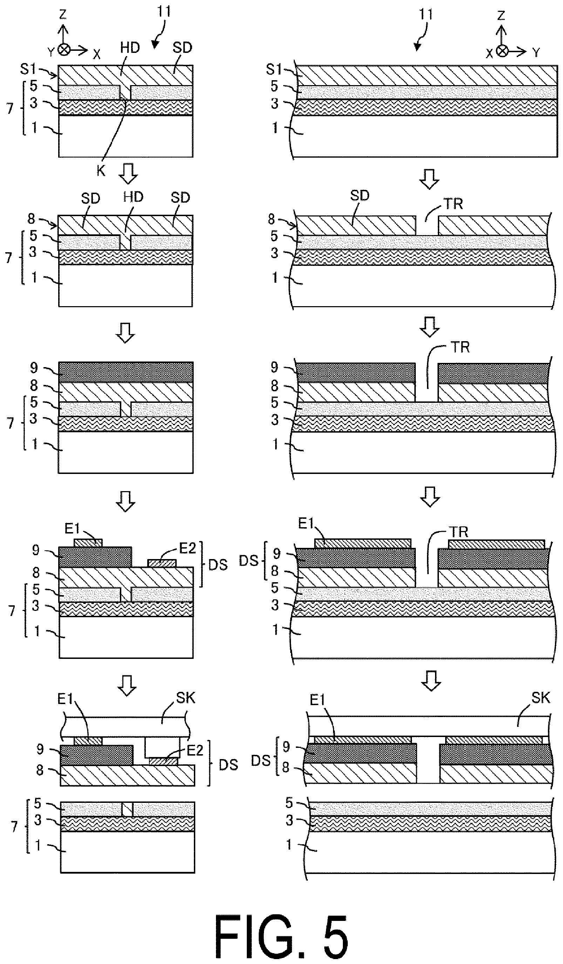

FIG. 3 is a flowchart illustrating a manufacturing method for a semiconductor device according to Example 1. FIG. 4 includes plan views each illustrating the manufacturing method for a semiconductor device according to Example 1. FIG. 5 includes cross-sectional views each illustrating the manufacturing method for a semiconductor device according to Example 1.

As illustrated in FIGs. 3 to 5, the manufacturing method for a semiconductor device of Example 1 performs a step of preparing the template substrate 7 including a main substrate 1 and the mask pattern 6 including the opening portion K and the mask portion 5, a step of forming the first semiconductor part S1 containing a nitride semiconductor (for example, a GaN-based semiconductor) over the mask portion 5 from the opening portion K, a step of dividing the first semiconductor part S1 into the plurality of base semiconductor parts 8 by forming a plurality of trenches TR in the first semiconductor part S1, a step of forming the compound semiconductor part 9 containing a nitride semiconductor (for example, a GaN-based semiconductor) on each of the plurality of base semiconductor parts 8, a step of forming a first electrode E1 and a second electrode E2, and a step of transferring an element portion (device laminate body) DS including the base semiconductor part 8 and the compound semiconductor part 9 from the template substrate 7 to a support substrate SK. The mask portion 5 of the template substrate 7 and the base semiconductor part 8 are separated from each other by transferring an element portion DS to the support substrate SK (causing the support substrate SK to hold the element portion DS). The mask pattern 6 may be a pattern of a mask layer, the first semiconductor part S1 may be a first semiconductor layer, the base semiconductor part 8 may be a base semiconductor layer, and the compound semiconductor part 9 may be a compound semiconductor layer.

For example, in the known technique, if the element formation layer is not completely protected, an unintended region may be etched by an etchant of PEC etching, and the quality of the semiconductor device may be lowered. When a chip having a size of 100 µm or less such as a micro LED is formed, element separation may be performed by dry etching, but in the case of the chip having a small size as described above, a side surface of the chip subjected to dry etching may be physically or chemically damaged by ionic atoms of an etchant. When the chip size is about 20 µm or less, a ratio of side surface damage to a light-emitting region of the chip is increased, and a light-emitting efficiency may be lowered. The side surface damage of the active layer (for example, a light-emitting layer of a light-emitting chip or a light-receiving layer of a light-receiving chip) may cause serious efficiency loss.

In Example 1, the etching damage is avoided by, for example, dividing the first semiconductor part S1 into the plurality of base semiconductor parts 8 before the compound semiconductor part 9 including the active layer is formed, and not performing etching for element division after the formation of the active layer. This can improve the quality of the semiconductor device including the compound semiconductor part 9.

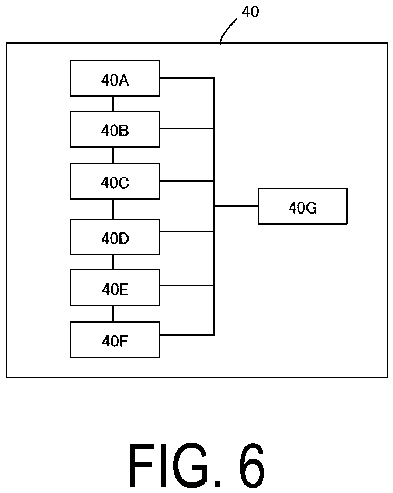

FIG. 6 is a block diagram illustrating a manufacturing apparatus for the semiconductor device according to Example 1. As illustrated in FIG. 6, the manufacturing method for a semiconductor device of Example 1 can be realized by the manufacturing apparatus 40 for the semiconductor device executing each step. The manufacturing apparatus 40 for the semiconductor device of Example 1 may include an apparatus 40A preparing the template substrate 7, an apparatus 40B forming the first semiconductor part S1, an apparatus 40C forming the plurality of trenches TR in the first semiconductor part S1, an apparatus 40D forming the compound semiconductor part 9, an apparatus 40E forming the first electrode E1 and the second electrode E2, an apparatus 40F transferring the element portion DS to the support substrate SK, and an apparatus 40G controlling the apparatuses 40A to 40F. For example, an MOCVD apparatus can be used for the apparatuses 40B and 40D. The apparatus 40B may be used as the apparatus 40D. For example, an etching apparatus can be used for the apparatus 40C. For example, a sputtering apparatus can be used for the apparatus 40E. The apparatuses 40C and 40E may include a photolithography apparatus. The apparatus 40G may include a processor and a memory. The apparatus 40G may be configured to control at least one of the apparatuses 40A to 40F by executing a program stored in a built-in memory, a communicable external device, or an accessible network, for example, and Example 1 also includes the program, and a recording medium and the external device storing the program therein.

In Example 1, the compound semiconductor part 9 is formed after the first semiconductor part S1 is divided into the plurality of base semiconductor parts 8. Thus, the state of the side surface of the compound semiconductor part 9 can be improved for the reason described above or the like as compared with a configuration in which the first semiconductor part serving as a base of the base semiconductor part and the second semiconductor part serving as a base of the compound semiconductor part are layered and then the first and second semiconductor parts are etched (configuration in which the side surface of the second semiconductor part is affected by etching).

In Example 1, all the trenches do not have to be formed before forming the active layer. The trench formation for chip peeling may be performed after the compound semiconductor part 9 is formed. On the other hand, the trench formation for chip peeling, for example, trench formation for removing a coupling portion (neck portion) of the base semiconductor part 8 may be performed before forming the active layer.

As illustrated in FIGs. 4 and 5, the template substrate 7 includes the main substrate 1, the seed portion 3 located on the main substrate 1, and the mask pattern 6 located on the seed portion 3. The mask pattern 6 includes the mask portion 5 and the opening portion K having a longitudinal shape. In the template substrate 7, the seed portion 3 is exposed from the opening portion K, and the first semiconductor part S1 starts crystal growth from above the seed portion 3 and is coupled to the seed portion 3.

In Example 1, the ELO method is used to form the first semiconductor part S1 containing the nitride semiconductor, for example, in a wire shape extending in the Y direction. In this case, before the semiconductor crystals laterally (X direction) grown in opposite directions on the mask portion 5 meet each other on the mask portion 5, the growth of semiconductor crystals is stopped. Thus, a gap GP is formed between the first semiconductor parts S1 adjacent to each other in the X direction. The X direction may be the <11-20> direction (a axis direction) of the base semiconductor part 8, the Y direction may be the <1-100> direction (m axis direction) of the base semiconductor part 8, and the Z direction may be the <0001> direction (c axis direction) of the base semiconductor part 8.

In Example 1, the plurality of trenches TR can be formed in the first semiconductor part S1 by etching. At least one of the plurality of trenches TR may extend in the width direction (X direction) of the opening portion K. At least one of the plurality of trenches TR may extend in the longitudinal direction (Y direction) of the opening portion K. The base semiconductor part 8 may be formed in an island shape (a state not connected to the periphery) by the plurality of trenches TR and gaps GP surrounding the base semiconductor part 8.

The etching of the first semiconductor part S1 may be dry etching, and the dry etching may be stopped at the mask portion 5. In this case, the mask portion 5 functions as an etching stopper, and the mask portion 5 is exposed at the bottom of the trench TR. In this case, the etching need not stop at the surface of the mask portion 5 and may stop in the mask portion 5. The mask portion 5 may be partially etched as long as the mask portion 5 is made of a material that is less likely to be etched than the first semiconductor part S1 and plays a role to stop etching.

Each of the compound semiconductor parts 9 may be formed in the island shape corresponding to a respective one of the base semiconductor parts 8. When the base semiconductor part 8 is formed in the island shape by the plurality of trenches TR and the gaps GP, the base semiconductor part 8 is surrounded by the mask portion 5 in plan view (viewed in the Z direction). The nitride semiconductor is hardly deposited on the mask portion 5 that is the mask for selective growth, and the compound semiconductor part 9 is grown on the upper surface and the side surface of the base semiconductor part 8 (containing the nitride semiconductor), and thus the compound semiconductor part 9 can be formed in the island shape. In this manner, patterning damage can be avoided and the state of the compound semiconductor part 9 can be improved. Also, a manufacturing process is simplified.

As illustrated in FIG. 4, when the trench TR is formed to extend in the width direction (X direction) of the opening portion K, warpage of the wafer can be reduced. This is noticeable when a heterogeneous substrate having a thermal expansion coefficient different from that of the base semiconductor part 8 is used for the main substrate 1. The main substrate 1 or the template substrate 7 may be referred to as a wafer, and the template substrate 7 and the semiconductor part thereon may also be collectively referred to as a wafer. For example, as illustrated in FIG. 4, the first semiconductor parts S1 adjacent to each other in the X direction are separated from each other by the gap GP. Thus, the warpage of the wafer in the X direction is small. However, the first semiconductor part S1 is continuously formed in the Y direction to be longer than the size (width) in the X direction, and thus the warpage of the wafer in the Y direction is large. However, a stress is relaxed and the warpage of the wafer in the Y direction is reduced by dividing the first semiconductor part S1 extending in the Y direction by the trench TR extending in the X direction before forming the active layer. Thus, when the active layer is formed, the wafer is less warped, and the temperature of the wafer surface during film formation can be easily kept uniform in the plane. Thus, the variation in the temperature of the wafer surface is small and when the active layer contains indium (In), for example, the variation in the In concentration can be reduced and the variation in emission wavelength in the wafer surface can be improved. This effect can be obtained even in a state where the trench TR does not reach the lower surface of the base semiconductor part 8 (a state where the trench TR stops halfway in the depth direction). In this case, the semiconductor chip can be peeled from the wafer by performing dry etching on the center portion of the trench TR again with a width smaller than the first trench width while protecting the side surface of the active layer. Thus, the trench TR formed before forming the active layer need not reach the mask portion 5.

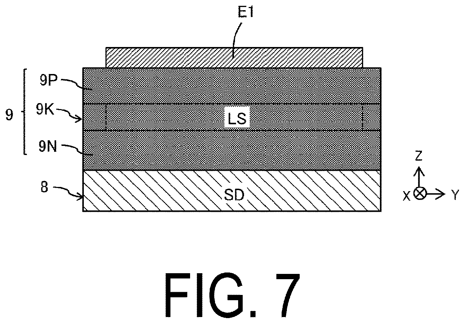

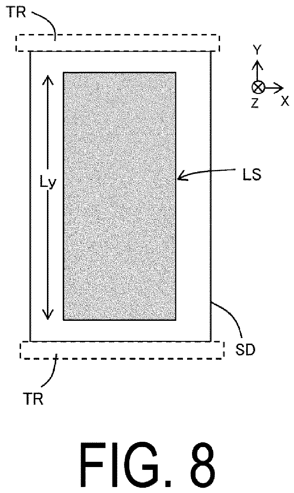

FIG. 7 is a partial cross-sectional view of an element portion of Example 1. FIG. 8 is a partial plan view of the element portion of Example 1. As illustrated in FIG. 7, the compound semiconductor part 9 may include an active portion (active layer) 9K. The state of the side surface of the active portion 9K can be improved by dividing the first semiconductor part S1 before forming the compound semiconductor part 9 and forming the base semiconductor part 8. An n-type portion 9N, the active portion 9K, and a p-type portion 9P may be formed in this order as the compound semiconductor part 9 on the base semiconductor part 8. The thickness of the compound semiconductor part 9 may be 1/2 or less of the thickness of the base semiconductor part 8. The sum of the thicknesses of the active portion 9K and the p-type portion 9P may be 1/2 or less of the base semiconductor part 8. The trench is less likely to be filled when the compound semiconductor part 9 is formed on the base semiconductor part 8 by setting the thickness of the compound semiconductor part 9 to 1/2 or less of the thickness of the base semiconductor part 8, and a peeling yield (peeling success rate) is improved.

By forming a regrowth layer (for example, a buffer layer containing an n-type GaN-based semiconductor) on the first semiconductor part S1 and forming the plurality of trenches TR in the first semiconductor part S1 and the regrowth layer, the plurality of base semiconductor parts 8 and the plurality of n-type portions obtained by dividing the regrowth layer may be formed. In this case, the active portion 9K and the p-type portion 9P can be formed as the compound semiconductor part 9 on the n-type portion on the base semiconductor part 8. That is, the trench TR for dividing the first semiconductor part S1 may be formed before the active portion 9K is formed, and the n-type portion may be formed on the first semiconductor part S1 and then the trench TR may be formed.

The base semiconductor part 8 may include a low-defect portion SD located above the mask portion 5, and the density of the threading dislocation (dislocation extending in the Z-axis direction) in the low-defect portion SD may be 5 × 10⁶/cm² or less. The threading dislocation density here can be obtained by, for example, performing cathode luminescence (CL) measurement (for example, counting the number of black spots) on the wafer surface (for example, the surface of the base semiconductor part 8 or the compound semiconductor part 9).
The threading dislocation density of the low-defect portion SD may be 1/5 or less of the threading dislocation density of a dislocation inheritance portion HD located on the opening portion K (on the seed portion 3). The threading dislocation density of the low-defect portion SD may be 5 × 10⁸/cm² or less. A basal plane dislocation may be a dislocation extending parallel to the c-plane (X-Y plane) of the base semiconductor part 8. The basal plane dislocation density here can be obtained by, for example, dividing the wafer to expose the side surface of the low-defect portion SD and performing CL measurement of the dislocation density of the side surface.

As illustrated in FIGs. 7 and 8, the active portion 9K of the compound semiconductor part 9 may include a light-emitting portion LS, and the entire light-emitting portion LS may overlap the low-defect portion SD in plan view. The size Ly of one side (for example, a side orthogonal to the adjacent trench TR) of the light-emitting portion LS may be 80 µm or less, 40 µm or less, 20 µm or less, 10 µm or less, or 5 µm or less. In Example 1, etching damage to the compound semiconductor part 9 (particularly, the active portion 9K) is avoided, and thus the size Ly of the one side of the light-emitting portion LS may be small.

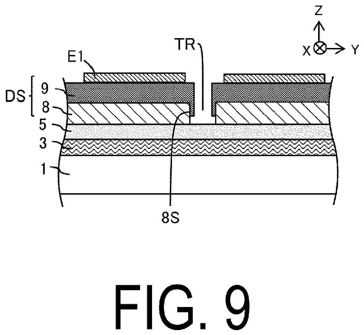

FIG. 9 is a partial cross-sectional view of the element portion of Example 1. As illustrated in FIG. 9, in the element portion DS, the compound semiconductor part 9 (including the active portion 9K) may be in contact with at least a part of the side surface of the base semiconductor part 8 (e.g., the side surface exposed by the trench TR and the side surface facing the gap GP).

The first electrode E1 that is the anode may be formed so as to overlap the low-defect portion SD in plan view and be in contact with the compound semiconductor part 9 (p-type portion 9P). When the nitride semiconductor of the base semiconductor part 8 is of the n type, the second electrode E2 that is the cathode can be formed so as to be in contact with the base semiconductor part 8. The second electrode E2 may be formed so as to be in contact with the n-type portion 9N of the compound semiconductor part 9.

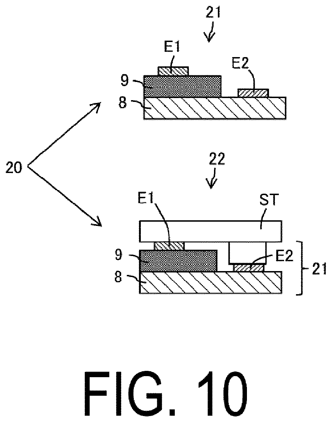

FIG. 10 includes cross-sectional views each illustrating a configuration of the semiconductor device of Example 1. A light-emitting body 21 (for example, an LED chip) can be obtained by peeling the element portion DS transferred to the support substrate SK from the support substrate SK. The light-emitting element 22 including the light-emitting body 21 and a support body ST thereof can be obtained by dividing the support substrate SK. Each of the light-emitting body 21 and the light-emitting element 22 can be referred to as a semiconductor device 20.

In Example 1, the element portion DS is coupled to the template substrate 7 through the opening portion K. Thus, in order to increase the peeling yield, the width of the opening portion K may be reduced so as to weaken a coupling force. Specifically, the width of the opening portion K may be set to 8 µm or less or may be set to 4 µm or less.

### Template Substrate

A heterogeneous substrate having a different lattice constant from that of a GaN-based semiconductor may be used for the main substrate 1. Examples of the heterogeneous substrate include a single crystal silicon (Si) substrate, a sapphire (Al₂O₃) substrate, and a silicon carbide (SiC) substrate. The plane orientation of the main substrate 1 is, for example, the (111) plane of the silicon substrate, the (0001) plane of the sapphire substrate, or the 6H-SiC (0001) plane of the SiC substrate. These are merely examples, and any main substrate and any plane orientation may be used as long as the first semiconductor part S1 can be grown by the ELO method. A SiC (bulk crystal) substrate, a GaN (bulk crystal) substrate, or an AlN (bulk crystal) substrate can be used as the main substrate 1.

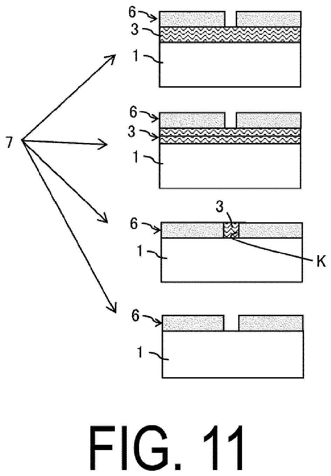

FIG. 11 includes cross-sectional views each illustrating a configuration example of a template substrate. The template substrate 7 may be configured such that the seed portion 3 (for example, AIN) and the mask pattern 6 are formed in this order on the main substrate 1 (for example, a silicon substrate), or may be configured such that a multi-layered seed portion 3 (for example, a lower layer portion containing at least one of AlN and SiC and an upper layer portion containing a GaN-based semiconductor) and the mask pattern 6 are formed in this order on the main substrate 1 (for example, a silicon substrate). The seed portion 3 may be locally formed (for example, in a stripe-shape) so as to overlap the opening portion K in plan view. The seed portion 3 may contain a nitride semiconductor formed at a low temperature of 600°C or less. This can reduce the warpage of the semiconductor substrate (the template substrate 7 and the element portion DS) caused by stress of the seed portion 3. The seed portion 3 can be film-formed using a sputtering apparatus (PSD: pulse sputter deposition, PLD: pulse laser deposition, or the like). The use of the sputtering apparatus has advantages in that low-temperature film formation and large-area film formation are possible, and the cost is reduced. As illustrated in FIG. 11, the template substrate 7 may be configured such that the mask pattern 6 is formed on the main substrate 1 (for example, a SiC bulk crystal substrate or a GaN bulk crystal substrate).

The opening portion K in the mask pattern 6 functions as a growth initiation hole through which the seed portion 3 is exposed and initiates the growth of the first semiconductor part S1. The mask portion 5 in the mask pattern 6 functions as a selective growth mask for lateral growth of the first semiconductor part S1. The region of the seed portion 3 exposed in the opening portion K may be referred to as a seed region. The mask portion 5 may be referred to as a growth suppression region or a selective growth region.

Examples of the mask portion 5 that can be used include a single-layer film including any one of a silicon oxide film (SiOx), a titanium nitride film (TiN or the like), a silicon nitride film (SiNx), a silicon oxynitride film (SiON), and a metal film having a high melting point (for example, 1000 degrees or higher), or a laminate film including at least two of the aforementioned.

For example, a silicon oxide film having a thickness of from about 100 nm to about 4 µm (preferably from about 150 nm to about 2 µm) is formed on the entire surface of the seed portion 3 by using sputtering, and a resist is applied onto the entire surface of the silicon oxide film. Thereafter, the resist is patterned by photolithography to form the resist including a plurality of stripe-shaped opening portions. Subsequently, a part of the silicon oxide film is removed with a wet etchant such as a hydrofluoric acid (HF) or a buffered hydrofluoric acid (BHF) to form a plurality of opening portions K, and the resist is removed by organic cleaning. Thus, the mask pattern 6 is formed. As another example, the silicon nitride film may be formed using a sputtering apparatus or a PECVD apparatus. Even if the silicon nitride film is thinner than the silicon oxide film, the silicon nitride film can withstand the film formation temperature of the base semiconductor part 8 at about 1000 degrees. The thickness of the silicon nitride film can be set to from about 5 nm to about 4 µm.

The opening portions K having the longitudinal shape (slit shape) can be periodically arrayed in the X direction. The width of the opening portion K may be set to from about 0.1 µm to about 20 µm. The smaller the width of the opening portion K, the smaller the number of threading dislocations propagating from the opening portion K to the first semiconductor part S1. The low-defect portion SD can be made large.

The silicon oxide film may be decomposed and evaporated in a small amount during film formation of the first semiconductor part S1 and may be taken into the first semiconductor part S1, but the silicon nitride film and the silicon oxynitride film have an advantage in terms of hardly decomposing and evaporating at a high temperature. Thus, the mask portion 5 may be a single-layer film of a silicon nitride or silicon oxynitride film, a layered film in which a silicon oxide film and a silicon nitride film are formed in this order on the seed portion 3, a laminate film in which a silicon nitride film and a silicon oxide film are formed in this order on the seed portion 3, or a layered film in which a silicon nitride film, a silicon oxide film, and a silicon nitride film are formed in this order on the underlying portion. A desired oxynitride film may be formed by controlling compositions of oxygen and nitrogen of SiON.

An abnormal portion such as a pinhole in the mask portion 5 may be eliminated by performing organic cleaning or the like after film formation and introducing the film again into a film forming device to form the same type of film. The mask portion 5 having a high quality may be formed by using a general silicon oxide film (single layer) and using the above-described re-formation method.

As an example of the template substrate 7, a silicon substrate having a (111) plane may be used as the main substrate 1, an AlN layer (from about 30 nm to about 300 nm, for example, 150 nm) may be used as the lower layer portion of the seed portion 3, a GaN-based graded layer may be used as the upper layer portion of the seed portion 3, and a laminate mask in which a silicon oxide film (SiO2) and a silicon nitride film (SiN) are formed in this order may be used as the mask portion 5. The GaN-based graded layer may include an Al_{0.6}Ga_{0.4}N layer (for example, 300 nm) that is a first layer and a GaN layer (for example, from 1 µm to 2 µm) that is a second layer. In the mask portion 5, by using a CVD method (plasma chemical vapor deposition method) for film formation of the silicon oxide film and the silicon nitride film, the thickness of the silicon oxide film can be, for example, 0.3 µm and the thickness of the silicon nitride film can be, for example, 70 nm.

### First Semiconductor Part

In Example 1, the first semiconductor part S1 (base semiconductor part 8) was the GaN layer, and ELO film formation of gallium nitride (GaN) was performed on the above-described template substrate 7 by using the MOCVD apparatus. The following may be adopted as examples of the ELO film formation conditions: substrate temperature: 1120°C, growth pressure: 50 kPa, trimethylgallium (TMG): 22 sccm, NH₃: 15 slm, and V/III = 6000 (ratio of group V raw material supply amount to group III raw material supply amount).

In this case, the first semiconductor part S1 was selectively grown (vertically grown) on the seed portion 3 exposed from the opening portion K and was subsequently laterally grown on the mask portion 5. The lateral growth was stopped before GaN crystal films laterally grown from both sides on the mask portion 5met each other.

The width (size in the X direction) of the mask portion 5 was 50 µm, the width (size in the X direction) of the opening portion K was 5 µm, the lateral width (size in the X direction) of the first semiconductor part S1 was 53 µm, the width (size in the X direction) of the low-defect portion SD was 24 µm, and the layer thickness (size in the Z direction) of the first semiconductor part S1 was 5 µm. The aspect ratio of the first semiconductor part S1 was 53 µm/5 µm = 10.6, and a very high aspect ratio was achieved. The width of the mask portion 5 can be set in accordance with specifications of the compound semiconductor part 9 and the like (for example, from about 10 µm to about 200 µm).

In the formation of the first semiconductor part S1 in Example 1, a longitudinal growth layer that grows in the Z direction (c-axis direction) is formed on the seed portion 3 exposed from the opening portion K, and then a lateral growth layer that grows in the X direction (a-axis direction) is formed. In this case, the thickness of the longitudinal growth layer being 10 µm or thinner, 5 µm or thinner, or 3 µm or thinner allows the thickness of the lateral growth layer to be reduced so as to be thin, increasing the lateral film formation rate.

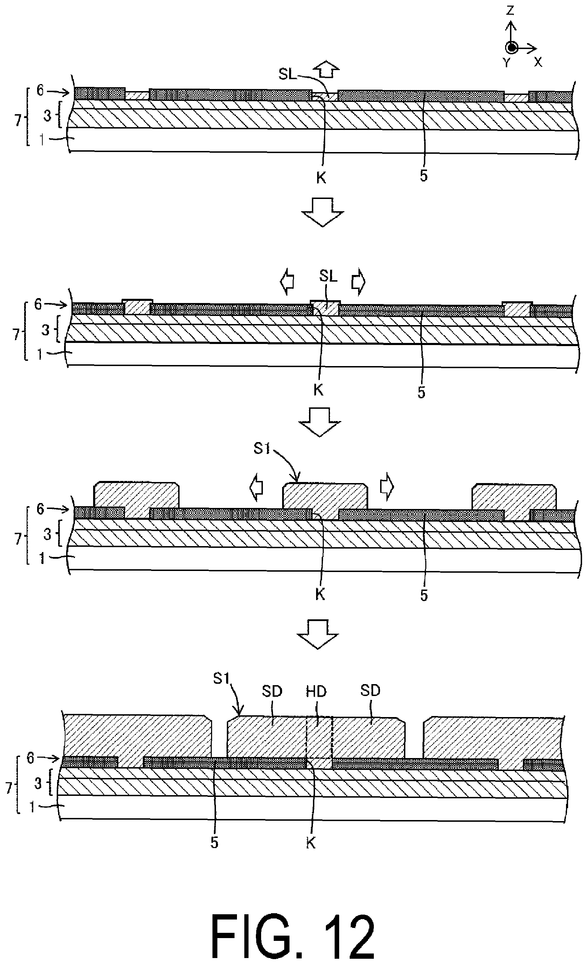

FIG. 12 includes cross-sectional views each illustrating an example of lateral growth of the first semiconductor part (ELO semiconductor layer). As illustrated in FIG. 12, an initial growth layer SL is formed on the seed portion 3 (GaN layer of the upper layer) exposed from the opening portion K, and then the first semiconductor part S1 is desirably laterally grown from the initial growth layer SL. The initial growth layer SL serves as a start point of the lateral growth of the first semiconductor part S 1. The initial growth layer SL can be formed to have a thickness of from 20 nm to 5000 nm, for example, from 50 nm to 400 nm, or from 70 nm to 350 nm. The first semiconductor part S1 may be controlled to grow in the Z direction (c-axis direction) or in the X direction (a-axis direction) by appropriately controlling the ELO film formation conditions.

Here, the film formation of the initial growth layer SL may be stopped just before the edge of the initial growth layer SL rides up to the upper surface of the mask portion 5 (when it is in contact with the top edge of the side surface of the mask portion 5) or just after it rides up to the upper surface of the mask portion 5 (that is, the ELO film formation conditions may be switched from the film formation conditions in the c-axis direction to the film formation conditions in the a-axis direction at this timing). In this manner, by performing the lateral growth from the state in which the initial growth layer SL slightly protrudes from the mask portion 5, growth of the first semiconductor part S 1 in the c-axis direction (thickness direction) can be suppressed, the first semiconductor part S1 can be laterally grown at a high speed and high crystallinity, and consumption of raw materials is also reduced. As a result, the first semiconductor part S1 (a crystalline body of the nitride semiconductor such as GaN) having a low number of defects can be formed in thin and wide manner at a low cost. The aspect ratio of the first semiconductor part S1 (the ratio of the size in the X direction to the thickness) can be set to 3.5 or more, 5.0 or more, 6.0 or more, 8.0 or more, 10 or more, 15 or more, 20 or more, 30 or more, or 50 or more.

### Compound Semiconductor Part and Electrode

The compound semiconductor part 9 can be formed using, for example, an MOCVD method. In the compound semiconductor part 9 in FIG. 7, for example, the n-type portion 9N is an n-GaN layer, the active portion 9K including the light-emitting portion LS is a multi-quantum well (MQW) including an InGaN layer and a GaN layer, and the p-type portion 9P has a layered structure of a p-AlGaN layer and a p-GaN layer. Thus, the element portion DS can be a light-emitting diode (LED). As described above, the n-type portion 9N may be formed from the regrowth layer on the first semiconductor part S 1.

The first electrode E1 (anode) and the second electrode E2 (cathode) may have a single-layer structure or a multi-layer structure containing at least one selected from the group consisting of Al, Ag, Cr Pd, Pt, Au, Ni, Ti, V, W, Cu, Zn, Sn, and In, and may include an alloy layer. At least one of the first and second electrodes E1 and E2 may have a layered structure of a translucent conductive film (Indium Tin Oxide (ITO) or the like) and a light reflective metallic film (Ag, Al, Ti, or the like).

### Variation

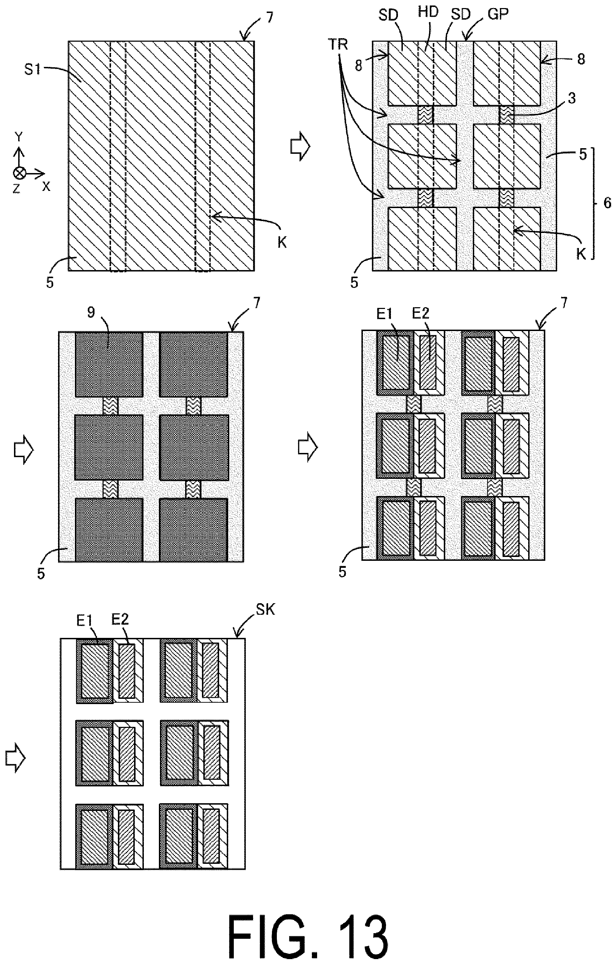

FIG. 13 includes plan views each illustrating another example of the manufacturing method for a semiconductor device according to Example 1. As illustrated in FIG. 13, the first semiconductor part S1 containing the nitride semiconductor may be formed in a planar shape by using the ELO method. In this case, at the time of film formation by the ELO method, the semiconductor crystals laterally (X direction) grown in opposite directions on the mask portion 5 may meet each other on the mask portion 5. The meeting of crystals occurs substantially at a center of the adjacent opening portions K (a center portion of the mask portion 5), and a void (gap) may be formed directly below the association portion. The void is formed inside the first semiconductor part S1 generated by the meeting of crystals and plays a role in releasing strain after the meeting of crystals. The plurality of base semiconductor parts 8 in the island shape are formed by forming the plurality of trenches TR extending in the X direction and the plurality of trenches TR extending in the Y direction in the first semiconductor part S1.

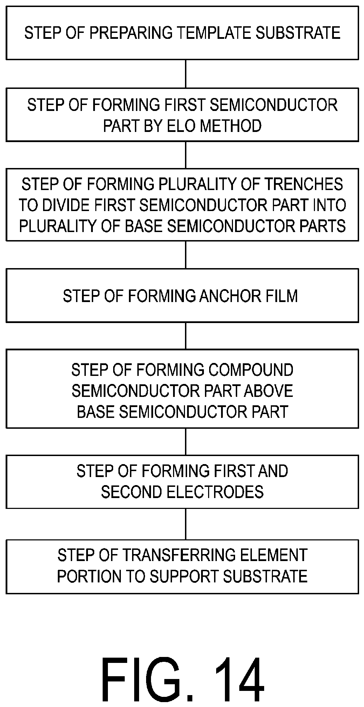

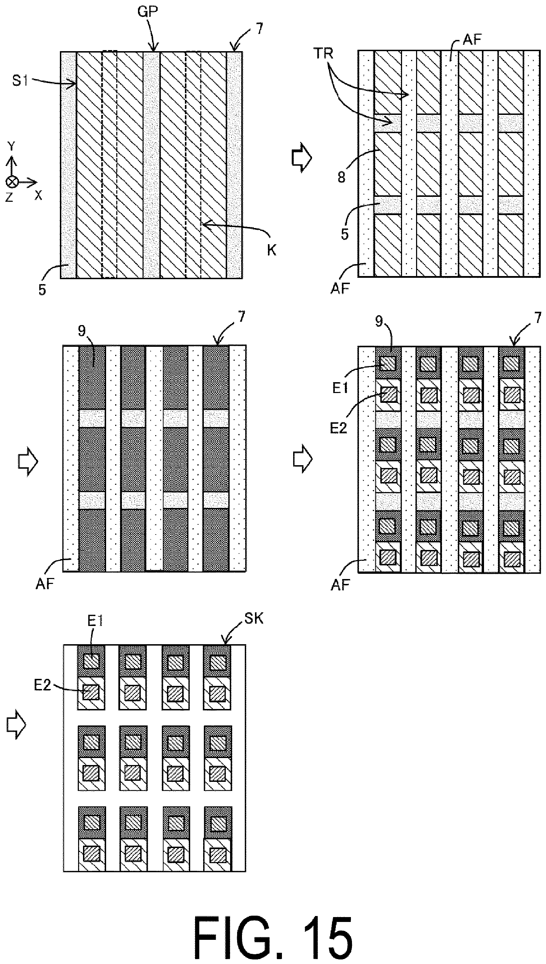

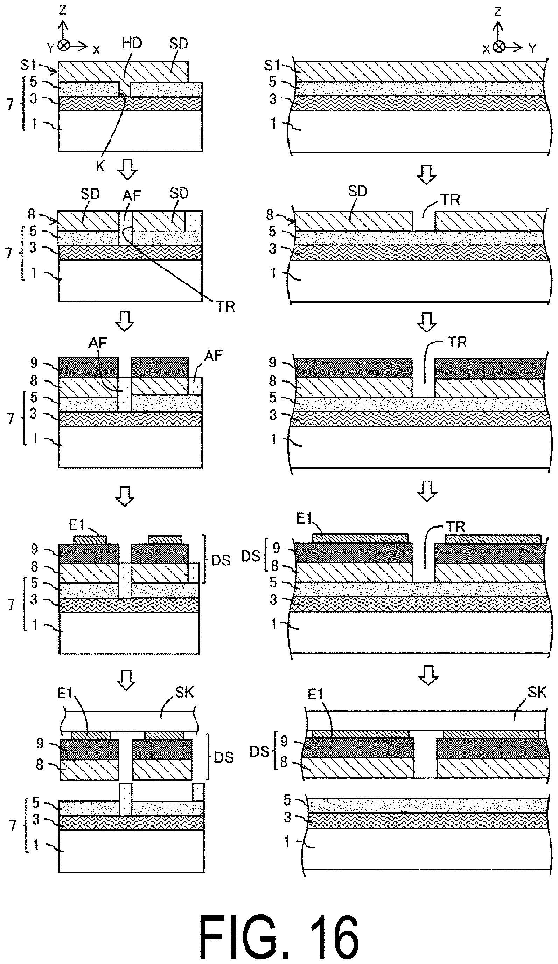

FIG. 14 is a flowchart illustrating another example of the manufacturing method for a semiconductor device according to Example 1. FIG. 15 includes plan views each illustrating an example of the manufacturing method for a semiconductor device according to FIG. 14. FIG. 16 includes cross-sectional views each illustrating the manufacturing method for a semiconductor device according to FIG. 14. As illustrated in FIGs. 14 to 16, a coupling portion between the first semiconductor part S1 and the seed portion 3 (a portion exposed from the opening portion K) may be removed by at least one of the plurality of trenches TR formed in the first semiconductor part S1. In this case, in order that the plurality of base semiconductor parts 8 in the island shape not be separated on the template substrate 7, an anchor film AF can be formed after the plurality of trenches TR are formed, and then the compound semiconductor part 9 can be formed.

The anchor film AF is in contact with the side surface of the base semiconductor part 8 and the mask portion 5 and anchors the base semiconductor part 8 to the template substrate 7. As the anchor film AF, a dielectric film, and the like such as a silicon oxide film, a silicon nitride film, an aluminum oxide film, a silicon oxynitride film, an aluminum oxide-silicon film, an aluminum oxynitride film, a zirconium oxide film, a titanium oxide film, or a tantalum oxide film can be used. When the silicon oxide film, the silicon nitride film, the aluminum oxide-silicon film, the silicon oxynitride film, the titanium nitride film, or the like is used as the anchor film AF, the nitride semiconductor of the compound semiconductor part 9 does not grow on the anchor film AF, so that the compound semiconductor part 9 can be formed in the island shape. At the time of transfer of the element portion DS, at least a part of the anchor film AF may remain on the template substrate 7 or may accompany the element portion DS.

An unnecessary portion of the anchor film AF can be lifted off by, for example, forming the trench TR by dry etching by using a resist mask, forming the anchor film AF on the entire surface by sputtering or an electron beem deposition (EB) method, and then removing the resist mask. A function of protecting the side surface of the chip (etching damage is known to occur on the side surface of the trench formed by dry etching) and a function of recovering damage are also achieved by using the anchor film AF for fixing the chip. The anchor film AF has no electrical conductivity, and thus, even if the anchor film AF finally remains on the chip, the anchor film AF may not cause electrical leakage or the like.

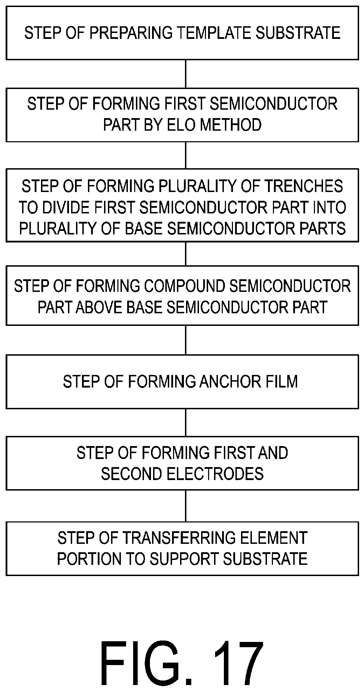

FIG. 17 is a flowchart illustrating another example of the manufacturing method for a semiconductor device according to Example 1. In FIG. 14, although the anchor film AF is formed before forming the compound semiconductor part 9, the configuration is not limited thereto. As illustrated in FIG. 17, the anchor film AF may be formed after the formation of the compound semiconductor part 9.

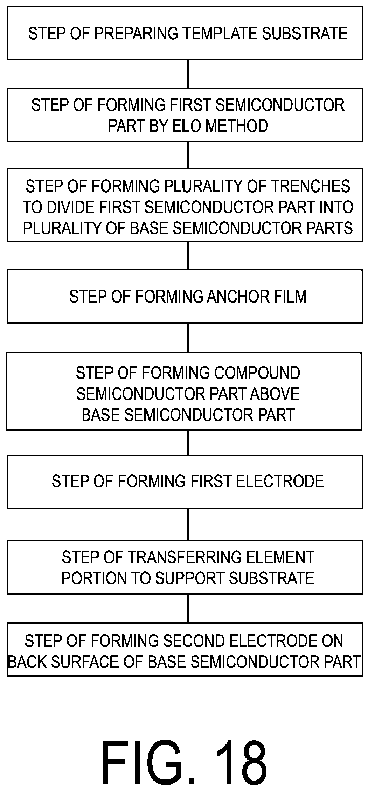

FIG. 18 is a flowchart illustrating another example of the manufacturing method for a semiconductor device according to Example 1. In FIGs. 14 and 16, the second electrode is formed on the upper surface of the base semiconductor part 8, but the configuration is not limited thereto. As illustrated in FIG. 18, the second electrode E2 (cathode) may be formed on the lower surface (back surface) of the base semiconductor part 8 after forming the first electrode E1 after the formation of the compound semiconductor part 9 and then transferring the element portion DS to the support substrate SK.

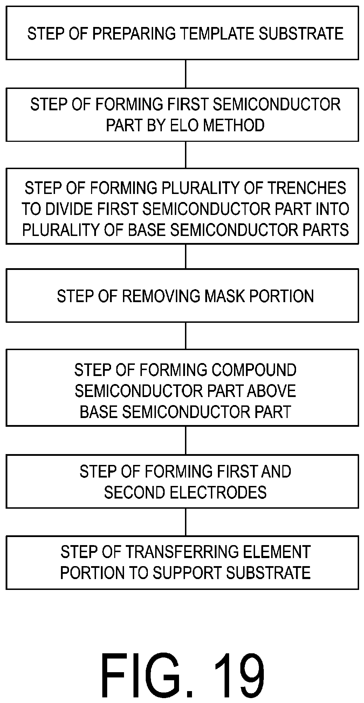

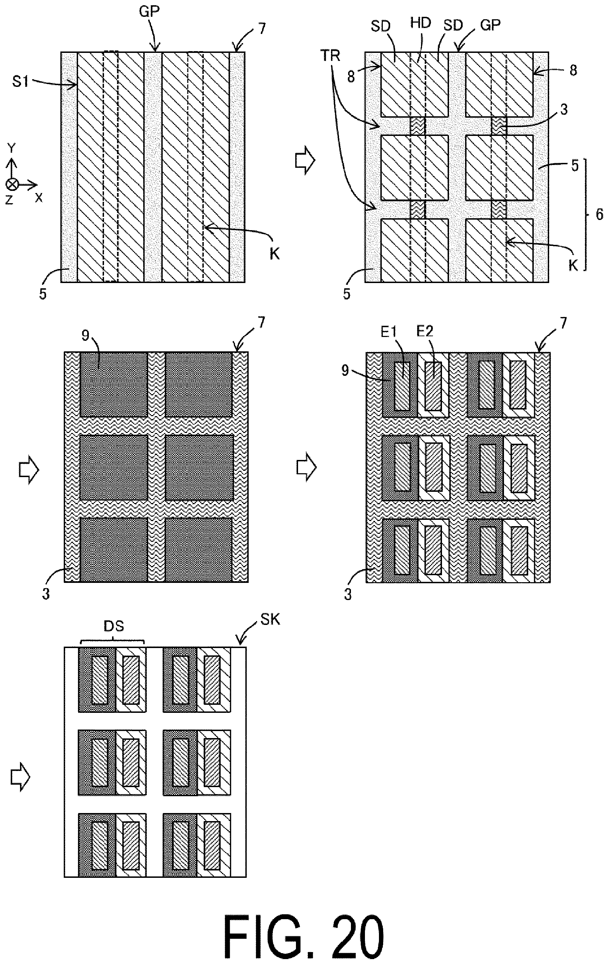

FIG. 19 is a flowchart illustrating another example of the manufacturing method for a semiconductor device according to Example 1. FIG. 20 includes plan views each illustrating the manufacturing method for a semiconductor device according to FIG. 19. As illustrated in FIGs. 19 and 20, the mask portion 5 may be removed after the base semiconductor part 8 is formed. For example, the mask portion 5 can be removed by etching by injecting an etchant into the plurality of trenches TR. This facilitates the transfer of the element portion DS to the support substrate SK. In order to increase the peeling (transfer) yield, the width of the opening portion K may be reduced to weaken the coupling force between the base semiconductor part 8 and the template substrate 7. Specifically, the width of the opening portion K may be set to 8 µm or less or may be set to 4 µm or less.

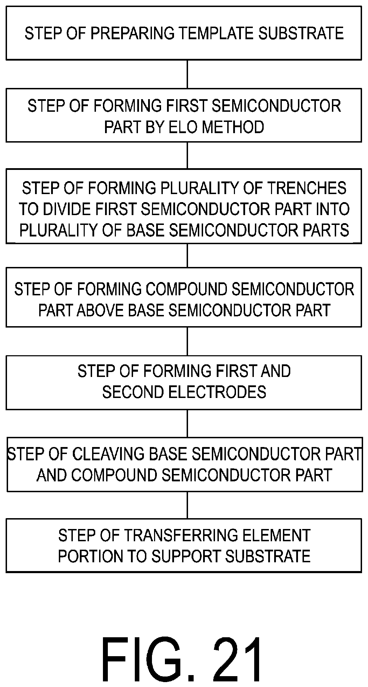

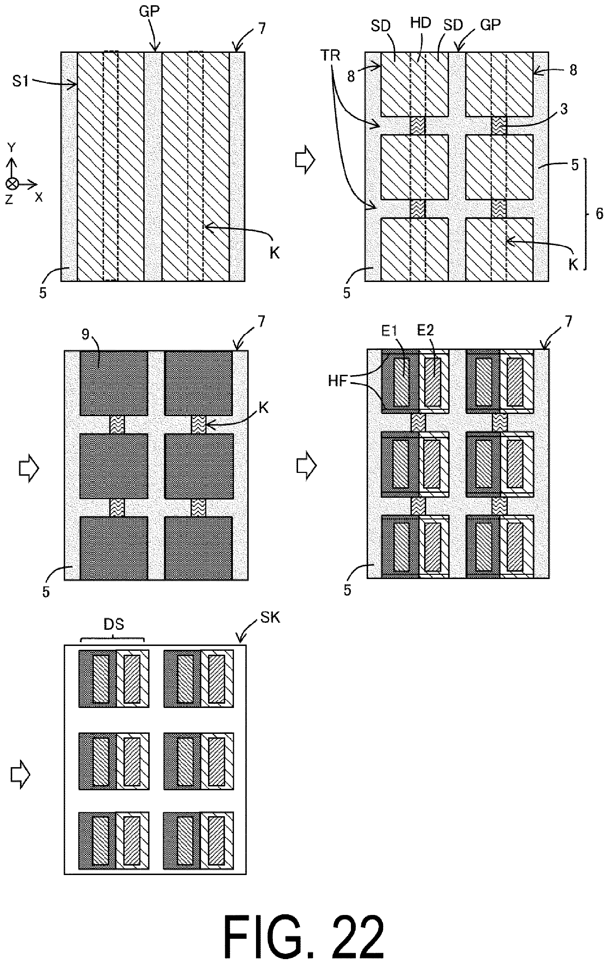

FIG. 21 is a flowchart illustrating another example of the manufacturing method for a semiconductor device according to Example 1. FIG. 22 includes plan views each illustrating the manufacturing method for a semiconductor device according to FIG. 21. As illustrated in FIGs. 21 and 22, after the compound semiconductor part 9 is formed, the base semiconductor part 8 and the compound semiconductor part 9 that are nitride semiconductor crystals, may be cleaved at, for example, an m-plane ((1-100) plane) HF having a normal parallel to the Y direction. When the element portion DS is the semiconductor laser, two cleavage planes facing each other in the Y direction (m-axis direction) are formed in the compound semiconductor part 9, and these cleavage planes can be used as resonator end faces. In FIG. 21, the cleavage is performed at the m-plane HF before the transfer to the support substrate SK, and the transfer is performed after the cleavage, but the configuration is not limited thereto. The cleavage may be performed on the support substrate SK after the transfer. In this case, each of the n-type portion 9N and the p-type portion 9P of the compound semiconductor part 9 may include a light guide layer and a cladding layer having refractive indices larger than a refractive index of the active portion 9K, and the p-type portion 9P may include a ridge (current constriction portion). Specifically, as the n-type portion 9N, a first contact layer (for example, an n-type GaN layer), a first cladding layer (for example, an n-type AlGaN layer), and a first light guide layer (for example, an n-type GaN layer) may be provided. The multi-quantum well (MQW) structure including the InGaN layer can be used for the active layer 9K. As the p-type portion 9P, an electron blocking layer (for example, a p-type AlGaN layer), a second light guide layer (for example, a p-type GaN layer), a second cladding layer (for example, a p-type AlGaN layer), and a second contact layer (for example, a p-type GaN layer) may be provided. As described above, the n-type portion 9N may be formed from the regrowth layer on the first semiconductor part S1.

### Semiconductor Device

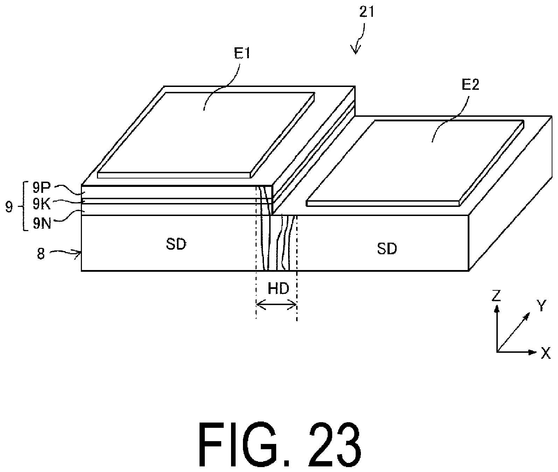

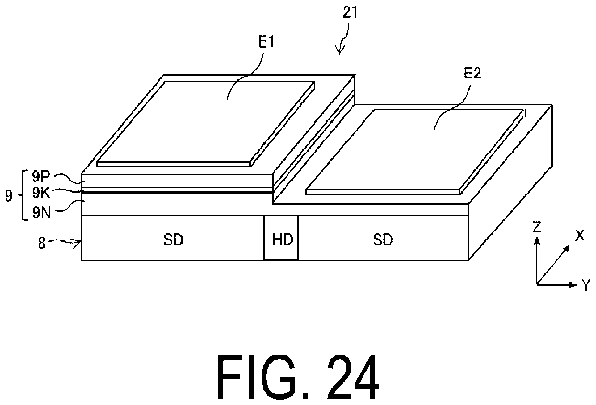

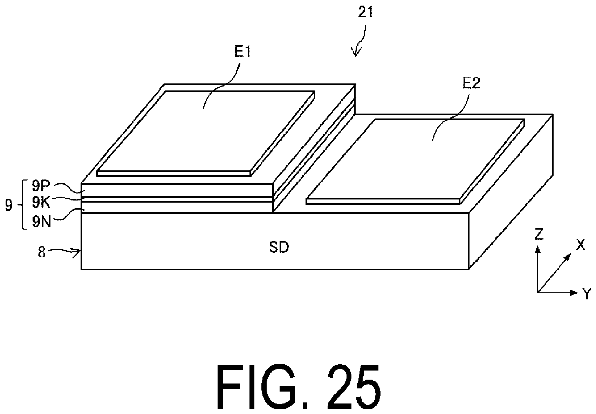

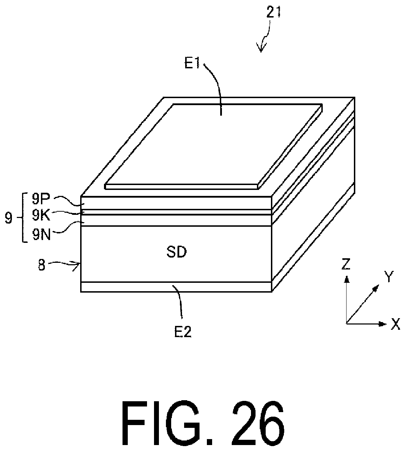

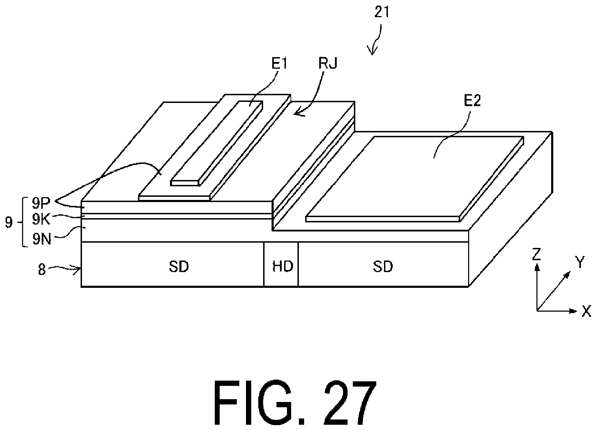

FIGs. 23 to 27 are perspective views each illustrating the configuration of the semiconductor device obtained by Example 1. For example, the light-emitting body (LED chip) 21 illustrated in FIG. 23 or 24 can be obtained by the manufacturing method in FIG. 3. In FIG. 23, the second electrode E2 is in contact with the base semiconductor part 8, and in FIG. 24, the second electrode E2 is in contact with the n-type portion 9N of the compound semiconductor part 9. For example, the light-emitting body 21 illustrated in FIG. 25 can be obtained by the manufacturing method in FIG. 14. For example, the light-emitting body 21 illustrated in FIG. 26 can be obtained by the manufacturing method in FIG. 18. For example, the light-emitting body 21 (semiconductor laser chip) illustrated in FIG. 27 can be obtained by the manufacturing method in FIG. 21. A ridge RJ is a current constriction portion, and laser light is emitted from a cleavage plane (m-plane) of the active portion 9K of the compound semiconductor part 9. The ridge RJ can be formed by dry etching the p-type portion 9P, and this etching is less likely to adversely affect the active portion 9K. A light reflecting film may be formed on the cleavage plane (m-plane) of the active portion 9K in FIG. 27. The light reflecting film can be made of, for example, a plurality of dielectric films. Examples of a material of the dielectric film include SiO₂, Al₂O₃, AIN, AlON, SiON, Nb₂O₅, TazOs, and ZrO₂. A laminate film including a plurality of these materials may be used as the light reflecting film.

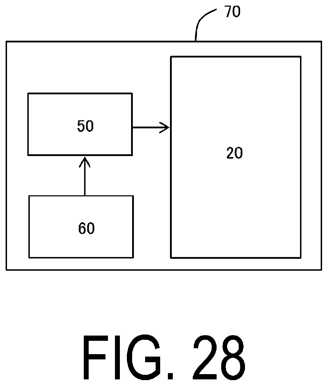

FIG. 28 is a schematic view illustrating a configuration of an electronic device including the semiconductor device obtained by Example 1. An electronic device 70 in FIG. 28 includes a semiconductor device 20 (for example, the light-emitting body 21 and the light-emitting element 22) obtained by Example 1, a drive circuit 50 driving the semiconductor device 20, and a control circuit 60 controlling the drive circuit 50. The control circuit 60 includes, for example, a processor and a memory. Examples of the electronic device 70 include display devices, lighting devices, light receiving devices, communication devices, measurement devices, information processing devices, medical apparatuses, and electric vehicles (EV).

### Example 2

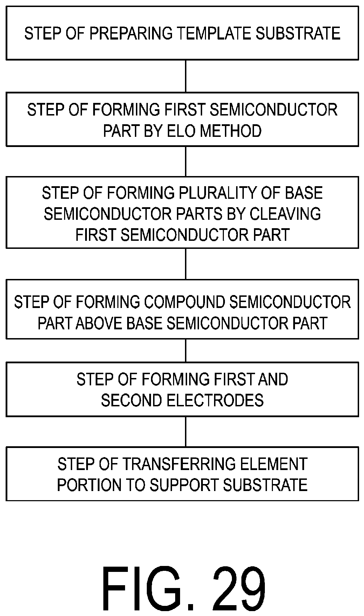

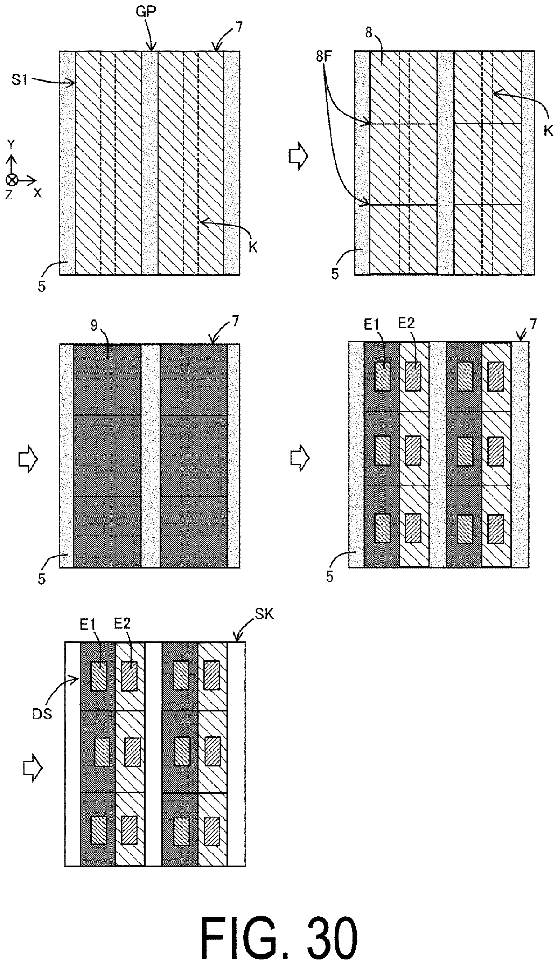

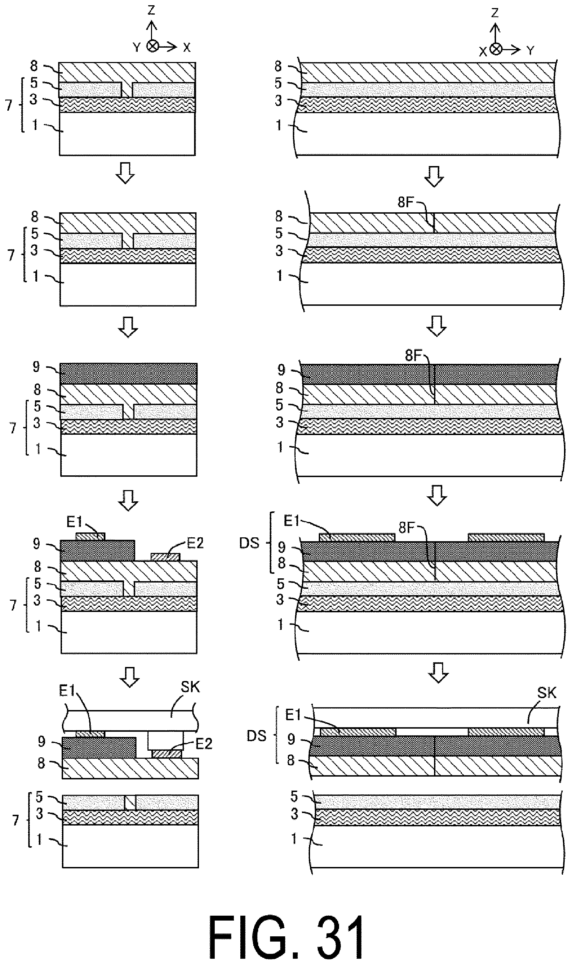

FIG. 29 is a flowchart illustrating a manufacturing method for a semiconductor device according to Example 2. FIG. 30 includes plan views each illustrating the manufacturing method for a semiconductor device according to Example 2. FIG. 31 includes cross-sectional views each illustrating the manufacturing method for a semiconductor device according to Example 2.

As illustrated in FIGs. 29 to 31, in Example 2, the following steps are performed: a step of preparing the template substrate 7 including the main substrate 1 and the mask pattern 6 including the opening portion K and the mask portion 5, a step of forming the first semiconductor part S1 containing a nitride semiconductor (for example, GaN-based semiconductor) over the mask portion 5 from the opening portion K, a step of dividing the first semiconductor part S1 into the plurality of base semiconductor parts 8 by cleaving the first semiconductor part S1 at an m-plane 8F of the nitride semiconductor, a step of forming the compound semiconductor part 9 containing a nitride semiconductor (for example, GaN-based semiconductor) on at least one of the plurality of base semiconductor parts 8, a step of forming the first electrode E1 and the second electrode E2, and a step of transferring the element portion (device laminate body) DS including the base semiconductor part 8 and the compound semiconductor part 9 from the template substrate 7 to the support substrate SK. The compound semiconductor part 9 may include the active portion (active layer) 9K.

By performing element division by cleavage, the volume of the first semiconductor part S1 to be eliminated is reduced as compared with the case where element division is performed by, for example, dry etching, and the wafer can be effectively used (as an element).

For example, when a heterogeneous substrate (Si substrate or the like) is used as the main substrate 1, warpage of the substrate (the template substrate 7 and the first semiconductor part S1) due to a stress resulting from a difference in thermal expansion coefficient between the main substrate 1 and the first semiconductor part S1 may occur. If the warpage occurs when the compound semiconductor part 9 is formed, the temperature of the growth surface becomes non-uniform, the composition of the compound semiconductor part 9 (for example, the indium concentration in the active portion 9K) varies in the plane, and the light-emitting characteristics may deteriorate. The stress in the first semiconductor part S1 is relaxed and the warpage of the substrate is reduced by cleaving the first semiconductor part S1 before forming the compound semiconductor part 9, so that the light-emitting characteristics (for example, in-plane evenness of the light-emitting wavelength) can be improved. The cleavage of the first semiconductor part S1 may be allowed to proceed naturally by scribing the first semiconductor part S1. The m-plane cleavage of the nitride semiconductor crystal may naturally proceed as internal stress is released. The n-type portion 9N, the active portion 9K, and the p-type portion 9P may be formed in this order as the compound semiconductor part 9.

The base semiconductor part 8 in the island shape separated from the periphery is formed by cleavage of the first semiconductor part S1, and thus the compound semiconductor part 9 in the island-shape can be formed on the base semiconductor part 8. In a case where the compound semiconductor part 9 does not become the island shape (a state of being separated from the periphery), the compound semiconductor part 9 in the island shape can be obtained by cleaving or patterning the nitride semiconductor crystal serving as the base of the compound semiconductor part 9 again.

By forming the regrowth layer (for example, the n-type GaN-based semiconductor) on the first semiconductor part S1 and cleaving the first semiconductor part S1 and the regrowth layer, the plurality of base semiconductor parts 8 and the plurality of n-type portions obtained by dividing the regrowth layer may be formed. In this case, the active portion 9K and the p-type portion 9P can be formed as the compound semiconductor part 9 on the n-type portion on the base semiconductor part 8.

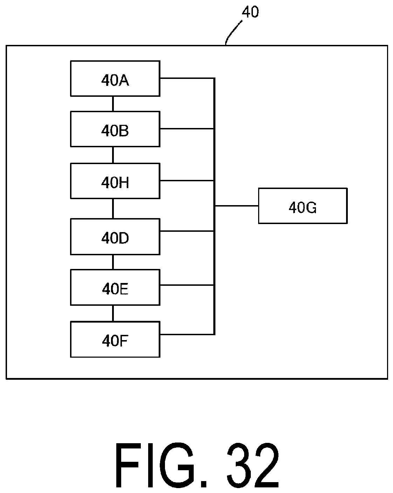

FIG. 32 is a block diagram illustrating a manufacturing apparatus for the semiconductor device of Example 2. The manufacturing apparatus 40 for the semiconductor device may include the apparatus 40A preparing the template substrate 7, the apparatus 40B forming the first semiconductor part S1, an apparatus 40H cleaving the first semiconductor part S1,the apparatus 40D forming the compound semiconductor part 9, the apparatus 40E forming the first electrode E1 and the second electrode E2, the apparatus 40F transferring the element portion DS to the support substrate SK, and the apparatus 40G. The apparatus 40G controls the apparatuses 40A, 40B, 40H and the apparatuses 40D to 40F.

When the element portions DS divided on the wafer by cleavage are transferred to the support substrate SK, the peeling may be selectively performed so as to straddle a plurality of the element portions, for example, every two or three element portions. This is possible because the base semiconductor part 8 is divided into small pieces on the wafer. When element separation is performed by cleavage, although the interval between the adjacent element portions is narrow, each element portion is bonded to the template substrate 7 through the opening portion, and thus only a desired element portion can be selectively peeled.

By selectively transferring every plurality of element portions to the support substrate SK, after the transfer to the support substrate SK, when the support substrate SK is divided into a plurality of single-chip mounted individual pieces (for example, light-emitting elements and light receiving elements), the individual piece size can be increased to facilitate handling and mounting of the individual piece in a desired package.

### Example 3

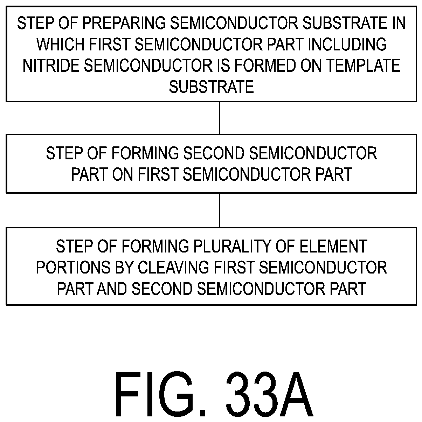

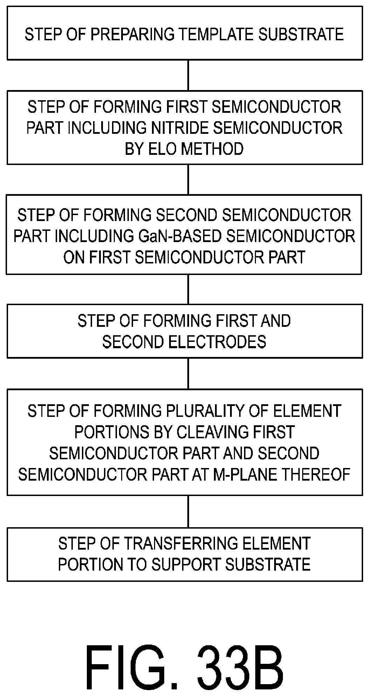

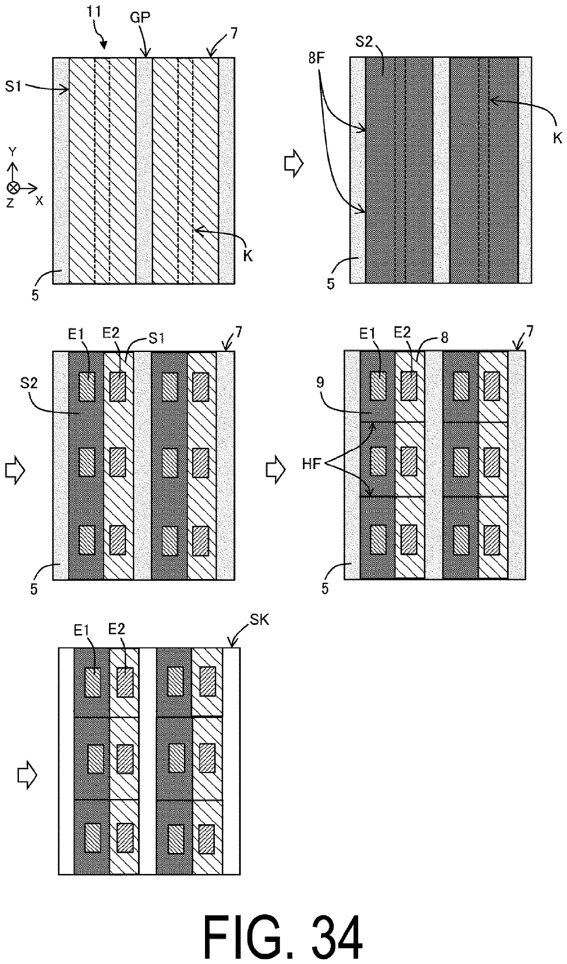

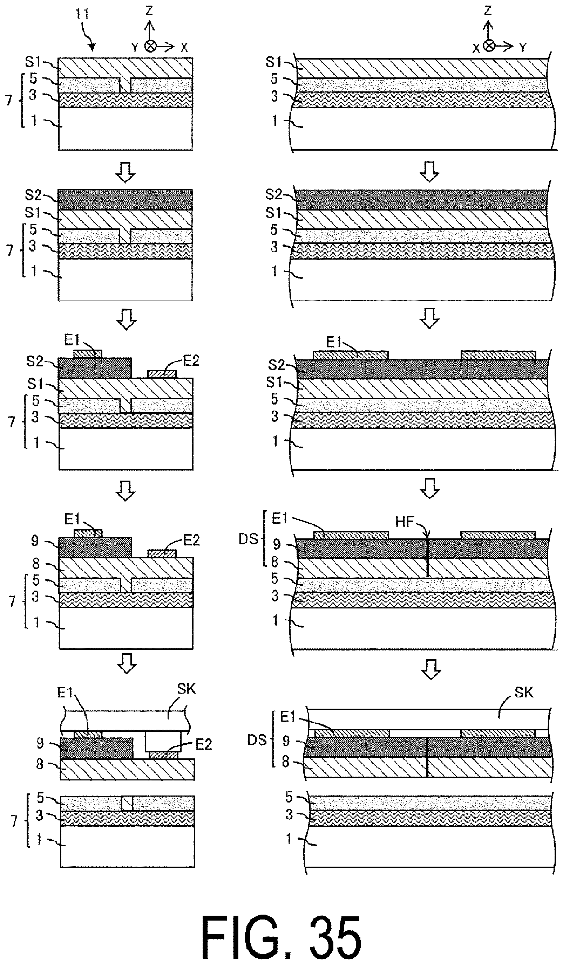

FIGs. 33A and 33B are flowcharts illustrating a manufacturing method for a semiconductor device according to Example 3. FIG. 34 includes plan views each illustrating the manufacturing method for a semiconductor device according to Example 3. FIG. 35 includes cross-sectional views each illustrating the manufacturing method for a semiconductor device according to Example 3.

As illustrated in FIG. 33A, the third embodiment may perform a step of preparing the semiconductor substrate 11 in which the first semiconductor part S1 containing the nitride semiconductor is formed on the template substrate 7, a step of forming a second semiconductor part S2 on the first semiconductor part S1, and a step of separating the first semiconductor part S1 and second semiconductor part S2 into a plurality of the element portions DS by cleaving the first semiconductor part S1 and second semiconductor part S2.

As illustrated in FIG. 33B, in Example 3, the following steps are performed: a step of preparing the template substrate 7 including the main substrate 1 and the mask pattern 6 including the opening portion K and the mask portion 5, a step of forming the first semiconductor part S1 containing the nitride semiconductor (for example, GaN-based semiconductor) over the mask portion 5 from the opening portion K, a step of forming the second semiconductor part (second semiconductor layer) S2 containing the nitride semiconductor on the first semiconductor part S1, a step of forming the first electrode E1 and the second electrode E2, a step of separating the first semiconductor part S1 and second semiconductor part S2 into the plurality of element portions DS by cleaving the first semiconductor part S1 and second semiconductor part S2 at the m-plane HF of the nitride semiconductor, and a step of forming the compound semiconductor part 9 containing a nitride semiconductor (for example, GaN-based semiconductor) on at least one of the plurality of base semiconductor parts 8, and a step of transferring the element portion (device laminate body) DS including the base semiconductor part 8 and the compound semiconductor part 9 from the template substrate 7 to the support substrate SK. The compound semiconductor part 9 may include the active portion 9K.

The element portion DS may be the LED or may be the semiconductor laser. When the element portion DS is the semiconductor laser, two cleavage planes HF facing each other in the Y direction (m-axis direction) are formed in the compound semiconductor part 9, and these cleavage planes HF can be used as resonator end faces.

The plurality of element portions DS can also be formed by forming the second semiconductor part S2 on the first semiconductor part S1 via the regrowth layer (for example, n-type GaN-based semiconductor) and cleaving the first semiconductor part S1, the regrowth layer, and the second semiconductor part S2.

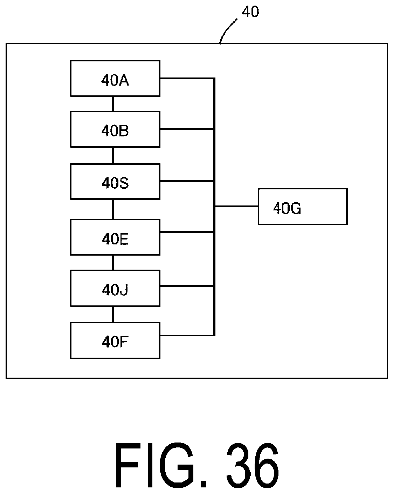

FIG. 36 is a block diagram illustrating a manufacturing apparatus for the semiconductor device of Example 3. The manufacturing apparatus 40 for the semiconductor device may include the apparatus 40A preparing the template substrate 7, the apparatus 40B forming the first semiconductor part S1, an apparatus 40S forming the second semiconductor part S2, the apparatus 40E forming the first electrode E1 and the second electrode E2, an apparatus 40J cleaving the first semiconductor part S1 and second semiconductor part S2, the apparatus 40F transferring the element portion DS to the support substrate SK, and the apparatus 40G. The apparatus 40G controls the apparatuses 40A, 40B, 40S, 40E, 40J, and 40F.

When the element portions DS divided on the wafer by cleavage are transferred to the support substrate SK, the peeling may be selectively performed across a plurality of the element portions, for example, every two or three element portions. This is possible because the base semiconductor part 8 is divided into small pieces on the wafer. When element separation is performed by cleavage, although the interval between the adjacent element portions is narrow, each element portion is bonded to the template substrate 7 through the opening portion, and thus only a desired element portion can be selectively peeled.

By selectively transferring the element portion of every plurality of element portions to the support substrate SK, after the transfer to the support substrate SK, when the support substrate SK is divided into a plurality of single-chip mounted individual pieces, the individual piece size can be increased to facilitate handling and mounting of the individual piece in a desired package.

### Example 4

In Examples 1 to 3, the GaN layer can be used for the first semiconductor part S1, but the configuration is not limited thereto. As the first semiconductor part S1 of Examples 1 to 3, an InGaN layer that is a GaN-based semiconductor layer can also be formed. The lateral film formation of the InGaN layer is performed at a low temperature below 1000°C, for example. This is because the vapor pressure of indium increases at a high temperature and indium is not effectively taken into the film. When the film formation temperature is low, an effect is exhibited in which the interaction between the mask portion 5 and the InGaN layer is reduced. The InGaN layer has an effect of exhibiting lower reactivity with the mask portion 5 than the GaN layer. When indium is taken into the InGaN layer at an In composition level of 1% or more, the reactivity with the mask portion 5 is further lowered, which is desirable. As the gallium raw material gas, triethylgallium (TEG) is preferably used.

The above-described technical forms are for illustrative and descriptive purposes and not intended to be limiting. It is apparent to those skilled in the art that many variations are possible based on these illustrations and descriptions.

### REFERENCE SIGNS

1 Main substrate
3 Seed portion
5 Mask portion
6 Mask pattern
7 Template substrate
8 Base semiconductor part
9 Compound semiconductor part
9K Active portion
11 Semiconductor substrate
20 Semiconductor device
21 Light-emitting body
22 Light-emitting element
40 Manufacturing apparatus for semiconductor device
K Opening portion
S1 First semiconductor part
S2 Second semiconductor part
TR Trench
DS Element portion
RJ Ridge portion
SD Low dislocation portion
HD Dislocation inheritance portion
E1 First electrode
E2 Second electrode
ST Support body
SK Support substrate

## Claims

1. A manufacturing method for a semiconductor device comprising the steps of:
preparing a semiconductor substrate in which a first semiconductor part is formed above a main substrate;
dividing the first semiconductor part into a plurality of base semiconductor parts; and
forming a compound semiconductor part above at least one of the plurality of base semiconductor parts.

2. The manufacturing method for a semiconductor device according to claim 1, wherein
the first semiconductor part is divided into the plurality of base semiconductor parts by forming one or more trenches in the first semiconductor part.

3. The manufacturing method for a semiconductor device according to claim 1, wherein
the first semiconductor part contains a GaN-based semiconductor, and
the first semiconductor part is separated into the plurality of base semiconductor parts by cleaving the first semiconductor part at an m-plane of the first semiconductor part.

4. The manufacturing method for a semiconductor device according to claim 2, wherein
the plurality of trenches are formed by etching.

5. The manufacturing method for a semiconductor device according to any one of claims 1 to 4, wherein
the compound semiconductor part comprises an active portion.

6. The manufacturing method for a semiconductor device according to claim 5, wherein
the compound semiconductor part comprises a p-type portion above the active portion.

7. The manufacturing method for a semiconductor device according to any one of claims 1 to 6, wherein
a template substrate comprising the main substrate and a mask pattern arranged above the main substrate and comprising a mask portion and an opening portion is prepared, and
the first semiconductor part is formed over the mask portion from the opening portion.

8. The manufacturing method for a semiconductor device according to claim 7, wherein
the template substrate comprises a seed portion exposed from the opening portion, and
the first semiconductor part is coupled to the seed portion.

9. The manufacturing method for a semiconductor device according to claim 7 or 8, wherein
the first semiconductor part is divided into the plurality of base semiconductor parts by forming a plurality of trenches in the first semiconductor part,
the opening portion has a longitudinal shape, and
at least one of the plurality of trenches extends in a width direction of the opening portion.

10. The manufacturing method for a semiconductor device according to any one of claims 7 to 9, wherein
the first semiconductor part is divided into the plurality of base semiconductor parts by forming a plurality of trenches in the first semiconductor part,
the opening portion has a longitudinal shape, and
at least one of the plurality of trenches extends in a longitudinal direction of the opening portion.

11. The manufacturing method for a semiconductor device according to claim 8, wherein
the first semiconductor part is divided into the plurality of base semiconductor parts by forming a plurality of trenches in the first semiconductor part, and
at least a part of a coupling portion between the first semiconductor part and the seed portion is removed by at least one of the plurality of trenches.

12. The manufacturing method for a semiconductor device according to any one of claims 7 to 11, further comprising
separating the plurality of base semiconductor parts and the mask pattern from each other after forming the compound semiconductor part.

13. The manufacturing method for a semiconductor device according to claim 7, wherein
at least one of the plurality of base semiconductor parts comprises a low-defect portion located above the mask portion, and
a threading dislocation density of the low-defect portion is 5 × 10⁶/cm² or less.

14. The manufacturing method for a semiconductor device according to claim 7, wherein
at least one of the plurality of base semiconductor parts comprises a low-defect portion located above the mask portion, and
a basal plane dislocation density of the low-defect portion is 5 × 10⁸/cm² or less.

15. The manufacturing method for a semiconductor device according to claim 13 or 14, wherein
the compound semiconductor part comprises an active portion, and
the active portion comprises a light-emitting portion located above the low-defect portion.

16. The manufacturing method for a semiconductor device according to any one of claims 1 to 15, wherein
a thickness of the compound semiconductor part is 1/2 or less of a thickness of at least one of the plurality of base semiconductor parts.

17. The manufacturing method for a semiconductor device according to any one of claims 1 to 16, wherein
the first semiconductor part contains a nitride semiconductor.

18. The manufacturing method for a semiconductor device according to claim 17, wherein
the first semiconductor part is divided into the plurality of base semiconductor parts by forming a plurality of trenches in the first semiconductor part, and
at least one of the plurality of trenches extends in a <1-100> direction or <11-20> direction of the nitride semiconductor.

19. The manufacturing method for a semiconductor device according to any one of claims 1 to 18, wherein
the compound semiconductor part contains a GaN-based semiconductor, and
the manufacturing method further comprises
cleaving the compound semiconductor part at an m-plane of the GaN-based semiconductor.

20. The manufacturing method for a semiconductor device according to any one of claims 1 to 19, wherein
the first semiconductor part is formed in a wire shape.

21. The manufacturing method for a semiconductor device according to any one of claims 1 to 19, wherein
the first semiconductor part is formed in a planar shape.

22. The manufacturing method for a semiconductor device according to claim 7, wherein
the first semiconductor part is divided into the plurality of base semiconductor parts by forming a plurality of trenches by dry etching in the first semiconductor part, and
the dry etching is stopped at the mask portion.

23. The manufacturing method for a semiconductor device according to any one of claims 1 to 22, wherein
the compound semiconductor part is formed in island shapes corresponding to the plurality of base semiconductor parts.

24. The manufacturing method for a semiconductor device according to any one of claims 1 to 23, wherein
at least one of the plurality of base semiconductor parts and the compound semiconductor part constitute an element portion.

25. The manufacturing method for a semiconductor device, according to claim 24, further comprising:
causing a support substrate to hold the element portion.

26. The manufacturing method for a semiconductor device according to any one of claims 13 to 15, further comprising:
forming a first electrode, the first electrode overlapping the low-defect portion in plan view and being in contact with the compound semiconductor part.

27. The manufacturing method for a semiconductor device according to claim 26, further comprising:
forming a second electrode, the second electrode being in contact with one of the plurality of base semiconductor parts.

28. The manufacturing method for a semiconductor device according to claim 27, wherein
the first electrode is an anode, and the second electrode is a cathode.

29. The manufacturing method for a semiconductor device according to claim 15, wherein
the opening portion has a longitudinal shape, and
a size of the light-emitting portion in a width direction of the opening portion is 20 µm or less.

30. The manufacturing method for a semiconductor device according to claim 8, wherein
the opening portion has a slit shape, and
the seed portion is formed to have a longitudinal shape and to overlap the opening portion.

31. The manufacturing method for a semiconductor device according to claim 12, wherein
the mask portion located below at least one of the plurality of base semiconductor parts is removed before forming the compound semiconductor part.

32. The manufacturing method for a semiconductor device according to claim 7, further comprising:
forming an anchor film in contact with at least one of the plurality of base semiconductor parts and the mask portion.

33. The manufacturing method for a semiconductor device according to claim 32, wherein
the anchor film is in contact with the compound semiconductor part.

34. The manufacturing method for a semiconductor device according to claim 3, wherein
cleavage of the first semiconductor part is caused to proceed naturally by scribing the first semiconductor part.

35. The manufacturing method for a semiconductor device according to claim 3, wherein
the compound semiconductor part contains a GaN semiconductor, and
the manufacturing method further comprises
cleaving the compound semiconductor part at an m-plane of the GaN-based semiconductor.

36. A manufacturing method for a semiconductor device comprising:
preparing a semiconductor substrate in which a first semiconductor part containing a nitride semiconductor is formed on a template substrate;
forming a second semiconductor part containing a GaN-based semiconductor on the first semiconductor part, and
separating the first semiconductor part and second semiconductor part into a plurality of element portions by cleaving the first semiconductor part and second semiconductor part at an m-plane of the first semiconductor part and second semiconductor part.

37. The manufacturing method for a semiconductor device according to claim 36, wherein
each of the plurality of element portions comprises a base semiconductor part and a compound semiconductor part, and
the compound semiconductor part comprises an active portion.

38. A manufacturing apparatus for a semiconductor device, wherein
the manufacturing apparatus performs each of the processes according to claim 1 or 36.
